# EUROPEAN PATENT SPECIFICATION

(11) **EP 4 328 174 B1**
(45) Date of publication and mention of the grant of the patent: **15.10.2025**
(21) Application number: 22191749.5
(22) Date of filing: 23.08.2022
(51) Int. Cl.: B82B 3/00

(54) **SUPPORT SUBSTRATE FOR NANOSTRUCTURES**
TRÄGERSUBSTRAT FÜR NANOSTRUKTUREN
SUBSTRAT DE SUPPORT POUR NANOSTRUCTURES

(43) Date of publication of application: 28.02.2024
(73) Proprietor: Chiral Nano AG, 8600 Dübendorf (CH)
(72) Inventor: WEIKERT, Sascha, 8057 Zürich (CH); LANZ, Natanael, 8600 Dübendorf (CH); BUTZERIN, Andre, 8049 Zürich (CH); JUNG, Seoho, 8134 Adliswil (CH)
(74) Representative: E. Blum & Co. AG

(56) References cited:
- CUBAYNES T ET AL: "Nanoassembly technique of carbon nanotubes for hybrid circuit-QED", APPLIED PHYSICS LETTERS, AMERICAN INSTITUTE OF PHYSICS, 2 HUNTINGTON QUADRANGLE, MELVILLE, NY 11747, vol. 117, no. 11, 17 September 2020 (2020-09-17), XP012250117, ISSN: 0003-6951, [retrieved on 20200917], DOI: 10.1063/5.0021838
- MUOTH M ET AL: "Transfer of carbon nanotubes onto microactuators for hysteresis-free transistors at low thermal budget", MICRO ELECTRO MECHANICAL SYSTEMS (MEMS), 2012 IEEE 25TH INTERNATIONAL CONFERENCE ON, IEEE, 29 January 2012 (2012-01-29), pages 1352 - 1355, XP032137478, ISBN: 978-1-4673-0324-8, DOI: 10.1109/MEMSYS.2012.6170417
- MATTHIAS MUOTH ET AL: "Suspended CNT-FET piezoresistive strain gauges: Chirality assignment and quantitative analysis", MICRO ELECTRO MECHANICAL SYSTEMS (MEMS), 2013 IEEE 26TH INTERNATIONAL CONFERENCE ON, IEEE, 20 January 2013 (2013-01-20), pages 496 - 499, XP032339282, ISBN: 978-1-4673-5654-1, DOI: 10.1109/MEMSYS.2013.6474287

## Description

### TECHNICAL FIELD

The present invention relates to a support substrate for nanostructures, in particular of carbon nanotubes. The support substrate serves to support nanostructures and to attach them to a device substrate. The invention also relates to an apparatus for attaching nanostructures to a device substrate by means of such a support substrate as well as to a method for attaching nanostructures to a device substrate by means of such a support substrate.

### PRIOR ART

Nanostructures are increasingly applied in nanoelectromechanical devices for a large variety of applications. In particular with respect to semiconductor devices, nanostructures are expected to play an important role in the future. Transistors and simple electronic circuits have already successfully been made with semiconducting and metallic carbon nanotubes.

A particular challenge in the fabrication of devices with nanostructures is the growth of individual - as opposed to bundled - nanostructures that are separated from each other and the correct transfer and attachment of the nanostructure from the growth substrate to the target device. In the prior art, a random or a parallel deposition of e.g. nanotubes on a device substrate with a plurality of devices is usually applied. With a random deposition, however, a large part of the devices need to be discarded, because none or too many nanostructures are deposited or the nanostructure is not correctly positioned on the device. As a result, the yield of devices when using such a random deposition procedure is rather low.

Growth of suspended or free-standing nanostructures in the form of e.g. carbon nanotubes between cantilevers has been recently developed, in order to overcome these problems associated with random deposition: By suspending the nanostructure between a pair of cantilevers, a carbon nanotube can be engineered far from any device, in which it will be applied later on. In this way, the nanostructure can be produced in an optimal environment and with minimal charge noise originating from e.g. a semiconductor device interface. By growing or depositing the suspended nanostructures between horizontal cantilevers, it is also possible to pre-select the nanostructures to be used by means of an optical method applying laser technology. By means of such a pre-selection, quality of the used nanostructures can be ensured using a non-destructive optical method (e.g. Raman spectroscopy). The growth substrate can then be approached to a device substrate, in order to transfer the pre-selected nanostructures to the devices, in which the nanostructures are to be used.

Growth of suspended nanostructures in the form of carbon nanotubes between cantilevers and subsequent transfer of the nanotubes to a nanoelectromechanical device has been demonstrated in e.g. Cubaynes, L.C. Contamin, M.C. Dartiailh, M.M. Desjardins, A. Cottet, M.R., Delbecq, T. Kontos, Nanoassembly technique of carbon nanotubes for hybrid circuit-QED, Appl. Phys. Lett. 117 (2020) 114001*.*

In M. Muoth, C. Hierold, Transfer of carbon nanotubes onto microactuators for hysteresis-free transistors at low thermal budget, 2012 IEEE 25th International Conference on Micro Electro Mechanical Systems (MEMS), IEEE (2012) 1352-1355, the assembly of a carbon nanotube field-effect transistor is disclosed by means of a growth substrate comprising cantilever structures.

Another prior art document which discloses the fabrication of devices using nanostructures that are held between two cantilevers of a growth substrate is V. Ranjan, G. Puebla-Hellmann, M. Jung, T. Hasler, A. Nunnenkamp, M. Muoth, C. Hierold, A. Wallraff, C. Schönenberger, Clean carbon nanotubes coupled to superconducting impedance-matching circuits, Nature Communications 6 (2015) 7165*.*

A further document that discloses the practice to grow nanostructures between horizontally extending cantilevers and to subsequently transfer them to a device substrate is e.g. S. Blien, P. Steger, A. Albang, N. Paradiso, A.K. Hüttel, Quartz Tuning-Fork Based Carbon Nanotube Transfer into Quantum Device Geometries, Phys. Status Solidi B. 255 (2018) 1800118*.*

The above-mentioned prior art methods for growing nanostructures and transferring them to the target device, have the disadvantage of limited scalability. For an industrial production of a large number of identical or similar devices, the methods known in the prior art so far are limited with regard to efficiency, i.e. manufacturing speed. Moreover, process control is limited, which inevitably leads to a large amount of discarded devices. Thus, the production of devices with nanostructures according to typical prior art methods is not very cost-effective. It is to be expected, however, that e.g. next generation sensors, computer chips and quantum processors will increasingly be used in the future. The ability for industrial mass production of such sensors, computer chips and quantum processors comprising nanostructures will be a key factor to widely apply this technology in a large variety of appliances.

### SUMMARY OF THE INVENTION

It is an object of the present invention to provide a support substrate for the production of nanostructures, in particular carbon nanotubes, which allows a particularly efficient and thus cost-effective fabrication of devices with these nanostructures.

This object is solved by a support substrate as claimed in claim 1. An apparatus for attaching nanostructures to a device substrate by means of such a support substrate is claimed in claim 9. Claim 14 provides a method for attaching such nanostructures to a device substrate. Further embodiments are provided in the dependent claims.

The present invention thus provides a support substrate for nanostructures, in particular for carbon nanotubes or graphene, the support substrate comprising a plurality of cantilever pairs which are each adapted to hold a nanostructure between them. At least some of the plurality of cantilever pairs are arranged such along at least a curved or angular part of the circumference of the support substrate that they extend in different, non-parallel directions.

By having a plurality of cantilever pairs that are arranged along at least a curved or angular part of the circumference of the support substrate in such a way that the cantilever pairs extend in different, non-parallel directions, the support substrate can have a significantly larger number of cantilevers and, thus, of nanostructures held thereon. Moreover, and even more importantly, the support substrate becomes scalable with regard to its size and number of cantilever pairs, because the mechanical collision between the support substrate and neighboring devices can be avoided to a considerable extent, if the cantilever pairs extend in different, non-parallel directions. In the prior art, the cantilevers are usually all arranged in parallel on one side of a rectangular support substrate, which leads to the problem that the cantilevers can collide with neighboring devices, when a nanostructure is transferred to a device. Since the devices are usually evenly spaced in rows next to each other on a device substrate in the form of e.g. a wafer or a pallet, the parallel extending cantilever can easily collide with neighboring devices, if the support substrate is scaled to a larger number of cantilever pairs that are all extending in parallel. Therefore, the usual production process according to the prior art has very limited scalability. In contrast, with the approach according to the invention, in which the cantilever pairs are arranged along at least a curved or angular part of the circumference of the support substrate in such a way that they extend in different, non-parallel directions, the provision of a larger support substrate with a larger number of cantilever pairs does not lead to collisions, or leads to collisions to a much lesser extent. Thus, the production process of the devices with the nanostructures, becomes scalable. A more efficient and therefore more cost-effective production of devices thus becomes possible.

Thus, due to the arrangement of the cantilever pairs along at least a curved or angular part of the circumference of the support substrate, preferably even along the entire circumference, the number of cantilever pairs can be increased significantly. In a preferred embodiment, the support substrate has more than 1'000 cantilever pairs, more preferably more than 3'000 cantilever pairs, most preferably more than 5'000 cantilever pairs. In comparison, rectangular support substrates according to the prior art having cantilevers only along one side of the substrate, usually only comprise 50 to 100 cantilever pairs.

In a preferred embodiment, the support substrate does not only serve to support nanostructures, but also to grow them. The support structure can in this case also be referred to as a growth structure that serves for the production of nanostructures. Growth of nanostructures between the cantilever pairs of the support substrate can be initiated by the provision of a suitable catalyst at the respective positions of the support structure. In other embodiments, the nanostructures are not grown on the support substrate, but are dispersed in a solution, from which they are transferred or "fished" onto the support substrate by immersing the cantilever pairs of the support structure in the solution. In yet another embodiment, the nanostructure are also not grown on the support structure, but are deposited onto the cantilever pairs, for example, by spraying.

A nanostructure is regarded to be a structure of intermediate size between microscopic and molecular structures. Nanostructures comprise structures in the range of nanometers (typically 1-100 nm). A nanostructure can have an elongated shape and be in the form of e.g. a nanotube or a nanowire. It can, however, also have a two-dimensionally extending shape and be in the form of e.g. a graphene variant, a transition-metal dichalcogenide layer or a boron nitride nanosheet. The nanostructures are preferably suspended or free-standing nanostructures.

Nanotubes, in particular carbon nanotubes, have two dimensions on the nanoscale, i.e. the diameter of the tube is between 0.1 and 100 nm. The length of a nanotube can, however, be far more.

The cantilevers preferably all extend from the outer circumference of a main portion of the support substrate outwardly. The extension of each cantilever is preferably along the horizontal direction, i.e. perpendicular to the direction of gravitation. Thus, each of the cantilevers preferably has an elongated bar- or rod-shaped design with a free end facing away from the main portion of the support substrate. Advantageously, each cantilever pair comprises two cantilevers extending in parallel. One or more nanostructures are then usually grown between the two cantilevers in a perpendicular direction. Thus, the cantiliever pairs are not only adapted to hold a nanostructure between them, but preferably also to grow a nanostructure between them. In other embodiments, the nanostructures are grown elsewhere before being deposited onto the cantilever pairs. The nanostructure is preferably attached to the target device by lowering the support substrate to a device substrate in such a way that the nanostructure comes to lie on the targeted position of the device. Thus, for the transfer of the nanostructure to the target device, the device or at least a part thereof is preferably positioned between the cantilevers.

In a particularly preferred embodiment, the plurality of cantilever pairs are distributed along the entire circumference of the support substrate. In the case of a circular support substrate, this means that the portions of the circumference, which are free of cantilever pairs, each span a circular arc of less than 90°, preferably less than 60°, more less than 45°, and most preferably less than 30°. In the case of a polygonal support substrate, a distribution of the plurality of cantilever pairs along the entire circumference means that each edge formed by the polygonal shape comprises at least one cantilever pair.

Each of the cantilever pairs preferably extends outwardly along an approximately radial direction of the support substrate. An approximately radial direction is understood to be a direction which deviates from the exact radial direction by preferably less than 45°, more preferably less than 20°, most preferably less than 5°.

The circumference of the support substrate preferably describes the overall shape of a circle or of a regular polygon. These regular geometric overall shapes of the support substrate are particularly well suited with regard to scalability.

The plurality of cantilever pairs can be, but do not need to be uniformly distributed along the entire circumference of the support substrate. Instead, they can also be arranged in groups of multiple cantilever pairs extending parallel to each other. The distances between the cantilever pairs within each group are then usually different and preferably smaller by an integral multiple than the distances between two groups. Alternatively or in addition, the groups can also deviate from each other by the direction along which the cantilever pairs extend. Preferably, any two adjacent groups of cantilever pairs extending parallel to each other are at an angle of not more than 10°, preferably of not more than 8°, more preferably of not more than 6°, to each other. Within each group, the cantilever pairs preferably extend in parallel. The cantilever pairs of different groups, however, can also extend along different directions. The arrangement of the cantilever pairs in groups brings about the advantage that the support substrate can be optimally adapted, with regard to the transfer of the nanostructures, to the device substrate on which the devices are usually evenly spaced in rows next to each other.

Within each group, the cantilever pairs are preferably evenly spaced apart. The groups are preferably uniformly distributed, i.e. at regular distances, and advantageously along the entire circumference of the support substrate. The groups can particularly be arranged along a circular circumference formed by a main portion of the support substrate. In the region of each group, the support substrate can have a radially extending portion which extends radially outwards from the main portion of the support substrate. The cantilevers then extend outwards from the radially extending portion. Thus, a radially extending portion can be associated to each group of multiple cantilever pairs.

Each group of multiple cantilever pairs preferably extends outwardly along an approximately radial direction, more preferably along the radial direction, of the support substrate. An approximately radial direction is understood to be a direction which deviates from the exact radial direction by preferably less than 45°, more preferably less than 20°, most preferably less than 5°.

The support substrate can, but does not have to, be made as a whole in one piece. Thus, in certain embodiments, the cantilever pairs can be made in one piece with the main portion of the support substrate. In other embodiments, however, the cantilever pairs, in particular the radially extending portions comprising the cantilever pairs, can be attached to the main portion of the support substrate in such a way, that they are not made in one piece and e.g. from a different material than the main portion. For example, the main portion of the support substrate can be in the form of a circular or polygonal plate to which a plurality of radially extending portions comprising cantilever pairs are attached along of its circumference. In this case, the radially extending portions, that comprise the cantilever pairs, together with the main portion form the support substrate. Thus, by e.g. attaching a plurality of state-of-the-art support substrates, which each have a rectangular shape with cantilever pairs arranged in parallel on only one side thereof, to the circumference of a circular or rectangular plate, an inventive support substrate can be provided in a particularly easy way.

Preferably, the support substrate as a whole has a planar shape. Thus, the extension of the support substrate along two perpendicular spatial direction is preferably at least a two-digit multiple, more preferably at least a three-digit multiple, greater than along a third perpendicular spatial direction. The plurality of cantilever pairs preferably extend within a common plane. Thus, preferably the extension of all cantilevers is within the same plane and, more preferably, within the same plane as the main portion of the support substrate.

Preferably, the device substrate as a whole has a planar shape. Thus, the extension of the device substrate along two perpendicular spatial direction is preferably at least a two-digit multiple, more preferably at least a three-digit multiple, greater than along a third perpendicular spatial direction. The devices to which the nanostructure are to be attached are formed by the device substrate in each case. The device substrate can comprise a single device only. Preferably, however, it comprises a plurality of devices, in particular of nanoelectromechanical devices. A nanoelectromechanical is an electromechanical device having functional components with dimensions in the nanometre range. The devices can particularly be semiconductor devices.

The present invention is also directed to an apparatus for attaching nanostructures, in particular carbon nanotubes, to a device substrate, the apparatus comprising
a holder for holding a support substrate as indicated above, comprising a plurality of cantilever pairs extending within a common plane in different, non-parallel directions; and
a positioner for positioning the device substrate to which one or more of the nanostructures are to be attached with respect to the support substrate.

The apparatus is adapted to move the holder and the positioner in such a way relative to each other, that the nanostructures, each held between a cantilever pair, are brought from the support substrate to a plurality of attachment points on the device substrate, in order to be attached to the device substrate.

The apparatus is adapted to rotate the support substrate about an axis of rotation that extends perpendicularly through the common plane of the plurality of cantilever pairs, in order to sequentially attach the nanostructures to the device substrate.

By rotating the support substrate for sequentially place the nanostructures on the devices of the device substrate, a particularly simple and efficient fabrication of the device can be achieved. The idea of having a support substrate with a curved or angular circumference and with non-parallel cantilever pairs as indicated further above is directly linked with the idea to rotate the support substrate for attaching the nanostructure to the device substrate. Thus, the support substrate and the apparatus as indicated above relate to a single inventive concept.

The apparatus is preferably a motorized apparatus, meaning that the holder can be moved relative to the positioner by means of a motor, in particular an electric motor.

The holder relates to a component of the apparatus, which allows attaching the support substrate to the apparatus, in order to transfer the nanostructures from the support substrate to the device substrate. The positioner serves to position the device substrate such that the nanostructures can be safely and accurately transferred from the support substrate to the device substrate. Thus, the positioner preferably serves to hold the device substrate in the required position during the transfer.

In a preferred embodiment, the holder is movable, in particular movable by a motor, while the positioner is stationary. It is also conveivable, however, that it is the outer way round or that both the holder and the positioner are movable in other embodiments.

In a particularly preferred embodiment, the axis of rotation is tilted or is tiltable with respect to the geometric normal of a device substrate plane in which the attachment points are arranged. Thus, the device substrate plane is defined by the arrangement of the attachment points. The attachment points are the points where the nanostructures are to be attached to the device substrate. In the case that the nanostructure is a carbon nanotube, there are usually two attachment points for each nanostructure. By tilting the axis of rotation with respect to the device substrate for the transfer of a nanostructure, a collision of the cantilevers with neighbouring devices can be avoided particularly well, while still ensuring a very accurate placing of the nanostructure on the device substrate.

The tilt angle by which the axis of rotation is tilted or is tiltable with respect to the geometric normal of the device substrate plane is preferably in the range from 1° to 40°, more preferably in the range from 4° to 20°, in particular from 4° to 10°. A tilt angle in these ranges has been proven to be particularly well suited for avoiding collisions on the one hand and for ensure an accurate placing on the other hand.

The apparatus is preferably adapted to move the support substrate relative to the positioner along an x-direction extending perpendicular to the axis of rotation. The apparatus is further adapted to move the support substrate relative to the positioner along a y-direction extending perpendicular to both the x-direction and the axis of rotation. In this way, nanostructures can efficiently be transferred to a multiple of device arranged next to each other.

The present invention furthermore relates to a method for attaching nanostructures, in particular carbon nanotubes, to a device substrate, in particular by means of an apparatus as indicated above, wherein the nanostructures are each arranged between a cantilever pair of a support substrate as indicated above, the cantilever pairs extending in different, non-parallel directions within a common plane, and wherein the method comprises at least the step of
- rotating the support substrate about an axis of rotation that extends perpendicularly through the common plane, in order to sequentially bring the nanostructures from the support substrate to a plurality of attachment points on the device substrate, in order to attach the nanostructures to the device substrate.

For attaching the nanostructures to the device substrate, the axis of rotation is preferably tilted with respect to the geometric normal of a device substrate plane in which the attachment points are arranged. Collisions can be avoided in this way.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1: shows a perspective view of a growth substrate according to the prior art in a starting position for the transfer of nanostructures to two devices arranged on a common device substrate;
- Fig. 2: shows a perspective view of the growth substrate and the device substrate of Fig. 1 during the transfer of a nanostructure to a device;
- Fig. 3: shows a perspective view of the growth substrate and the device substrate of Fig. 1 after the transfer of the nanostructure to the device has been completed;
- Fig. 4a: shows a view from above onto a growth substrate according to an inventive embodiment;
- Fig. 4b: shows an enlarged detail view of the rectangular area marked by a dashed line in Fig. 4a, with a plurality of radially extending portions of the growth substrate being recognizable;
- Fig. 4c: shows an enlarged detail view of the rectangular area marked by a dashed line in Fig. 4b, with a single radially extending portion of the growth substrate being recognizable;
- Fig. 4d: shows an enlarged detail view of the rectangular area marked by a dashed line in Fig. 4c, with the cantilever pairs of a radially extending portion of the growth substrate being recognizably including the nanostructures held by some of the cantilever pairs;
- Fig. 5a: shows a perspective view of an apparatus according to an inventive embodiment during the attachment of a nanostructure to a device substrate by means of the growth substrate of Fig. 4a;
- Fig. 5b: shows a side view of the apparatus of Fig. 5a;
- Fig. 5c: shows a top view of the apparatus of Fig. 5a;
- Fig. 5d: shows an enlarged detail view of the rectangular area marked by a dashed line in Fig. 5c; and
- Fig. 5e: shows an enlarged detail view of the rectangular area marked by a dashed line in Fig. 5d.

### DESCRIPTION OF PREFERRED EMBODIMENTS

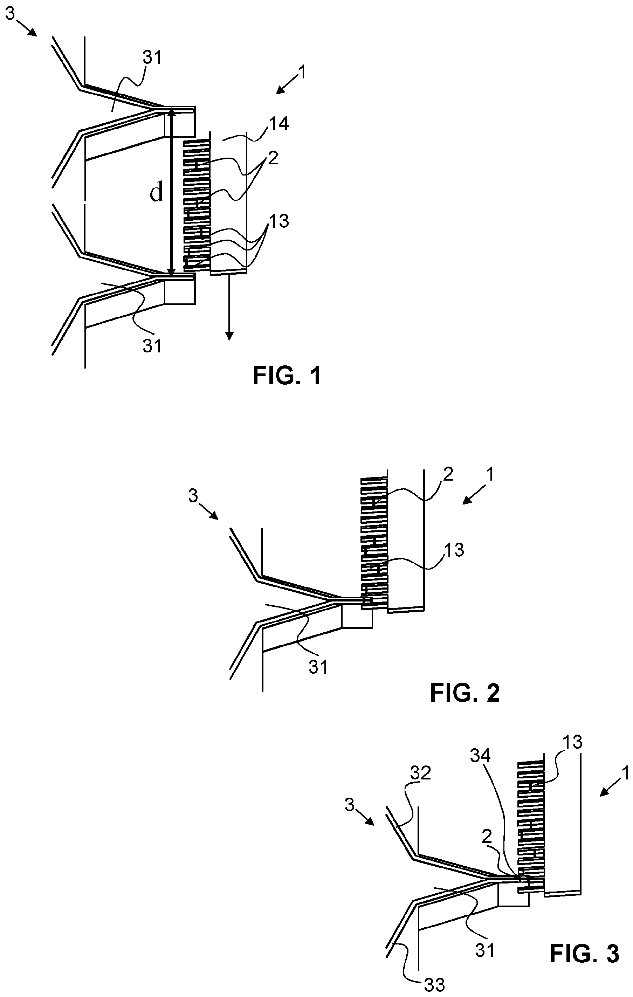

Figures 1 to 3 show a support substrate in the form of a growth substrate 1 according to the prior art in different positions with respect to a device substrate 3. As can be seen, the state-of-the-art growth substrate 1 has as a whole a flat rectangular shape and comprises a plurality of cantilever pairs 13 that are arranged in parallel along one side of a main portion 14 of the growth substrate 1. A nanostructure 2 is held between at least a part of the cantilever pairs 13 in each case, which can e.g. be in the form of a carbon nanotube. The nanostructures 2 preferably extend perpendicularly with regard to the extension of the cantilevers.

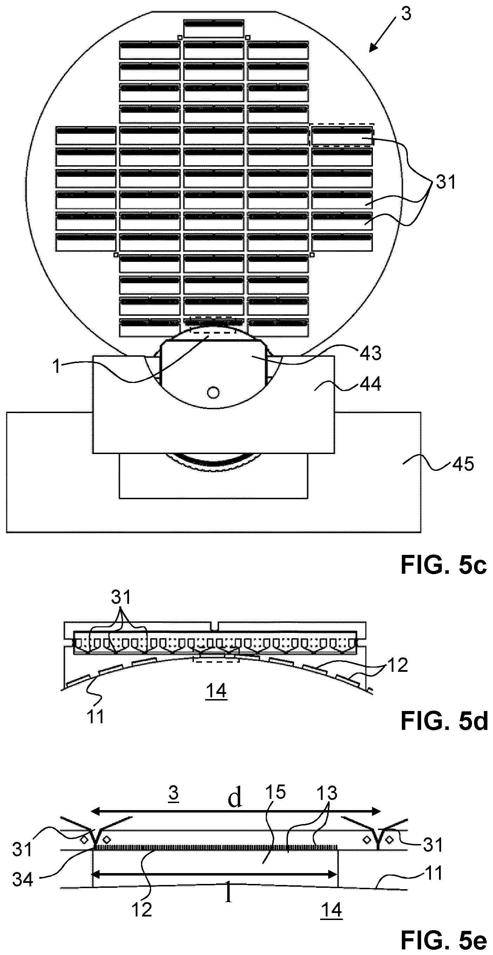

The device substrate 3 comprises a plurality of devices 31, which are usually arranged in rows of several devices 31 parallel next to each other, as can also been seen from e.g. figure 5c. For transferring the nanostructures 2 to the devices 31, the growth substrate 1 is positioned close to the device substrate 3 in such a way, that a cantilever pair 13 holding a nanostructure 2 is arranged above the device to which the respective nanostructure 2 is to be attached (figure 1). The growth substrate 1 is then lowered with respect to the device substrate 3 along the direction as indicated by the arrow in figure 1 until the nanostructure 2 gets into contact with the device 31 in the desired position and orientation (figure 2). The growth substrate 1 is then lowered further and moved away from the device substrate 3. In doing so, the nanostructure 2 remains in its position on the device 31, as can be seen in figure 3.

The devices 31 to which the nanostructures 2 are attached can for example form a transistor or another electronic circuit in each case. As it is shown in figure 3, the nanostructure 2 can particularly be in the form of a carbon nanotube that is placed in such a way on the device 31 forming a transistor that it connects a drain 32 to a source 33 of the device 31. The positions on the device substrate 3, where the nanostructures 2 are to be attached, are referred to as attachment points 34.

As can be seen from figure 1, the length of the growth substrate 1 along the side, which comprises the cantilever pairs 13, is limited by the distance d between the devices 31: If the length of the growth substrate 1 is too long, the cantilever pairs 13 collide with a neighboring device 31. Usually, the device substrate 3 is in the form of a wafer of a given size(see figure 5c), which means that increasing the distance d between the devices 31 is only possible at the cost of less devices 31 per wafer. Thus, with state-of-the-art growth substrates 1, scalability towards an industrial production of a large number of identical or similar devices is limited.

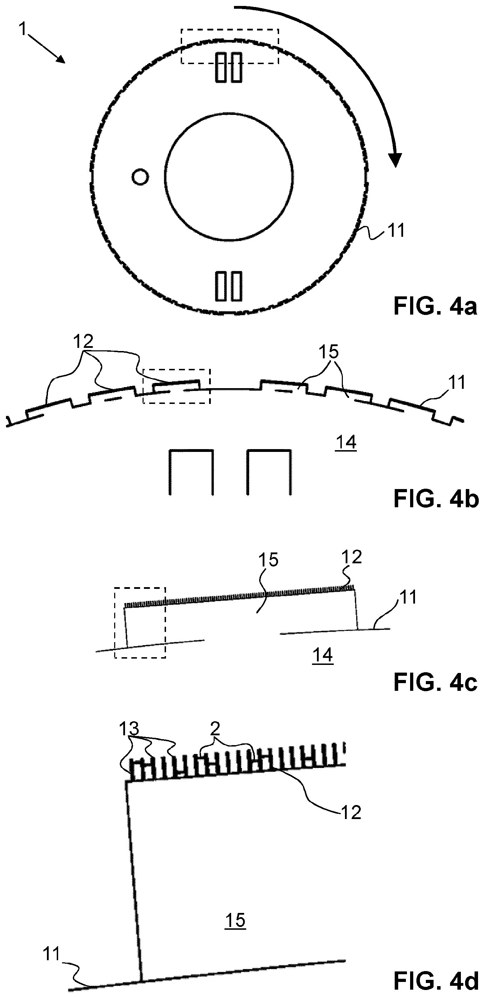

Figures 4a to 4d show a support substrate in the form of a growth substrate 1 according to an inventive embodiment. Since the support substrate here not only serves to support nanostructures 2, but also to grow them beforehand, the support substrate is referred to as a growth substrate 1. In other embodiments, it would of course also be possible that the nanostructures 2 are not grown on the support substrate, but instead elsewhere, and that the support substrate only serves to support the nanostructure 2, in order to transfer them to a device substrate. Thus, the growth substrate 1 shown in figures 4a to 4d could generally also be a support substrate that is not used to grow nanostructures.

As can be seen from figure 4a, the growth substrate 1 has a generally flat, plate-shaped form with a circular, i.e. curved, circumference 11. The growth substrate 1 further comprises a plurality of radially extending portions 15 which are each connected to a main portion 14 of the growth substrate 1 and are extending radially outwards therefrom. The main portion 14 forms a circle or ring area. The radially extending portions 15 are arranged at certain distances with respect to each other along the circumference 11 of the growth substrate 1.

A plurality of cantilever pairs 13 are provided on each radially extending portion 15, as can be seen from figure 4d. The cantilever pairs 13 of each radially extending portion 15 together form a group 12 of multiple cantilever pairs 13 that extend in parallel to each other and are arranged in regular distance relative to each other (see figures 4b to 4d).

The radially extending portions 15 can be made in one piece and from the same material as the main portion 14. In certain embodiments, however, it is also possible that the radially extending portions 15 with the cantilever pairs 13 are made separately from the main portion 14 and are only attached to the latter. In this case, the radially extending portions can be made from the same or from a different material than the main portion 14. It is even possible in such an embodiment that the radially extending portions 15 are formed by a state-of-the-art growth substrate 1 in each case, e.g. as shown in figures 1-3. Due to the attachment of the radially extending portions 15 to the circumference 11 of the main portion 14, the main portion 14 together with the radially extending portions 15 then forms a growth substrate 1 according to an inventive embodiment.

The arrangement of the cantilever pairs 13 along the curved circumference 11 of the growth substrate 1 brings about the advantage that the growth substrate 1 can have a much larger number of cantilever pairs 13 as compared to the state-of-the-art growth substrate 1 of figures 1-3. Due to the curved circumference of the growth substrate and the non-parallel extensions of the groups 12 of cantilever pairs 13, there is no risk of collision with neighboring devices 31 during the transfer of a nanostructure 2 to a device 31.

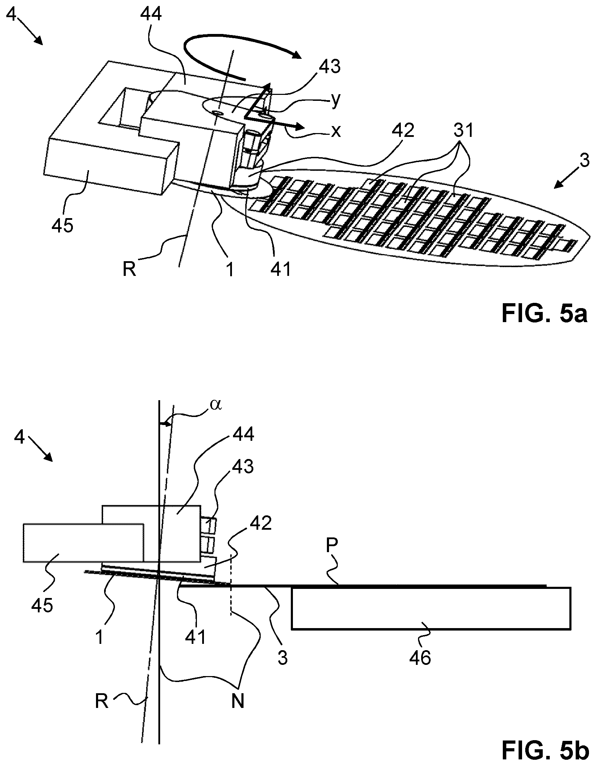

Figures 5a to 5e show a preferred embodiment of an apparatus 4 that serves to attach nanostructures 2 that have been grown or deposited on an inventive support substrate to a device substrate 3. The support substrate can be in the form of a growth substrate 1 as the one of figures 4a to 4d.

The apparatus 4 comprises a holder 41 for holding the growth substrate 1, preferably in such a way that the growth substrate 1 can be released from the holder 41. The holder 41 is attached to a rotating disc 42 of the apparatus 4. The rotating disc 42 is rotatable, together with the holder 41 and the growth substrate 1 attached thereto, about an axis of rotation R. The rotating disc 42 is in turn attached to a pivoting block 43 of the apparatus 4, which allows tilting the rotating disc 42 by a tilt angle α and, thus, the axis of rotation R with respect to the geometric normal N of the device substrate 3. The geometric normal N is defined by a device substrate plane P in which the attachment points 34 of the device substrate 3 are arranged. In the present case, the device substrate plane P coincides with the flat upper surface of the device substrate 3. The pivoting block 43 is attached, in a pivotable manner, to a connection block 44 held by a mounting bracket 45.

The device substrate 3 is held by a positioner 46, which can be, but does not need to be, stationary. The positioner 46 serves to hold and position the device substrate 3 with respect to the growth substrate 1.

The ability to rotate the growth substrate 1 allows one nanostructure 2 held by the pairs of cantilevers 13 to be transferred to the device substrate 3 at a time.

The tilting of the axis of rotation R with respect to the normal N allows a particularly precise transfer of a nanostructure 2 to a device 31, with a significantly decreased risk that the growth substrate 1 or parts of the apparatus 4 collide with the device substrate 3. In this respect, reference is made to figure 5b, where it can be seen that due to the tilting of the axis of rotation R with respect to the normal N of the device substrate 3, only a small part of the circumference 11 of the growth substrate 1 comes into contact with the device substrate 3.

In order to bring the nanostructures 2 to the plurality of attachment points 34, where they are to be attached to the device substrate 3, the mounting bracket 45 and, thus, the apparatus 4 as shown in figures 5a and 5b can be displaced along an x-direction and a y-direction (x and y in figure 5a). The x-direction and the y direction extend perpendicularly to each other and perpendicularly in each case to the geometric normal N of the device substrate plane P in which the attachment points 34 are arranged.

In certain embodiments, the apparatus 4 as shown in figures 5a and 5b can also be capable of being rotated about the axis of rotations R as a whole. Such a rotation of the entire apparatus 4 can be advantageous, in order to correct alignment errors before the transfer if the nanostructures 2.

Figures 5d and 5e show detail views of the growth substrate 1 and of the device substrate 3 during the transfer of a nanostructure 2 by means of the apparatus 4. The ability to precisely position a certain cantilever pair 13 of the growth substrate 1 with respect to the device substrate 3 becomes particularly evident from figures 5d and 5e: Due to the curved circumference of the growth substrate 1, only a single radially extending portion 15 with a respective group 12 of cantilever pairs 13 comes into contact with the device substrate 3. The fork length l of each radially extending portion 15 measured perpendicularly to the extension of the respective cantilever pairs 13 is dimensioned such as to be shorter than the distance d between the devices 31. In this way, there is no risk for a collision of a radially extending portion 15 with a neighboring device 31 during the transfer of a nanostructure 2. It is possible to transfer the nanostructures 2 held by the same group 12 of cantilever pairs 13 one after each other to the device substrate 3, before the growth substrate 1 is rotated about the axis or rotation R, in order to transfer the nanostructures 2 of another group 12 to the device substrate 3. A large number of nanostructures 2 of multiple groups 12 can be transferred in this way without having to replace the growth substrate 1.

The invention is of course not limited to the embodiments as shown in the figures. A large variety of modifications is possible. For example, the main portion 14 of the support substrate or growth substrate does not necessarily have to have a circular circumference. Instead, it could also have a polygonal circumference, such as for example a triangular, square or rectangular or any other polygonal circumference having more than four corners/edges. The cantilever pairs do not necessarily have to be arranged along the entire circumference 11, but could also be arranged along only a part of the circumference. Further modifications are possible.

### LIST OF REFERENCE SIGNS

| | | | |
|---|---|---|---|
| 1 | Growth substrate | 41 | Holder |
| 11 | Circumference | 42 | Rotating disc |
| 12 | Group | 43 | Pivoting block |
| 13 | Cantilever pair | 44 | Connection block |
| 14 | Main portion | 45 | Mounting bracket |
| 15 | Radially extending portion | 46 | Positioner |
| 2 | Nanostructure | R | Axis of Rotation |
| | | x | x-direction |
| 3 | Device substrate | y | y-direction |
| 31 | Device | α | Tilt angle |
| 32 | Drain | d | Device distance |
| 33 | Source | I | Fork length |
| 34 | Attachment point | N | Normal |
| | | P | Device substrate plane |
| 4 | Apparatus | | |

## Claims

1. A support substrate (1) for nanostructures (2), in particular for carbon nanotubes, the support substrate (1) comprising a plurality of cantilever pairs (13) which are each adapted to hold a nanostructure (13) between them,
**characterized in that**
at least some of the plurality of cantilever pairs (13) are arranged such along at least a curved or angular part of the circumference (11) of the support substrate (1) that they extend in different, non-parallel directions.

2. The support substrate (1) according to claim 1, wherein the plurality of cantilever pairs (13) are distributed along the entire circumference (11) of the support substrate (1).

3. The support substrate (1) according to claim 1 or 2, wherein each of the cantilever pairs (13) extends outwardly along an approximately radial direction.

4. The support substrate (1) according to one of the preceding claims, wherein the circumference (11) of the support substrate (1) describes the overall shape of a circle or of a regular polygon.

5. The support substrate (1) according to one of the preceding claims, wherein the cantilever pairs (13) are arranged in groups (12) of multiple cantilever pairs (13) extending parallel to each other.

6. The support substrate (1) according to claim 5, wherein the groups (12) of multiple cantilever pairs (13) extending parallel to each other are arranged at regular distances and preferably along the entire circumference (11) of the support substrate (1).

7. The support substrate (1) according to claims 5 or 6, wherein any two adjacent groups (12) of cantilever pairs (13) extending parallel to each other are at an angle of not more than 10°, preferably of not more than 8°, more preferably of not more than 6°, to each other.

8. The support substrate (1) according to one of the preceding claims, wherein the plurality of cantilever pairs (13) extend within a common plane.

9. An apparatus (4) for attaching nanostructures (2), in particular carbon nanotubes, to a device substrate (3), the apparatus (4) comprising
a holder (41) for holding a support substrate (1) according to one of the preceding claims, comprising a plurality of cantilever pairs (13) extending within a common plane in different, non-parallel directions; and
a positioner (46) for positioning the device substrate (3) to which one or more of the nanostructures (2) are to be attached with respect to the support substrate (1);
wherein the apparatus (4) is adapted to move the holder (41) and the positioner (45) in such a way relative to each other, that the nanostructures (2), each held between a cantilever pair (13), are brought from the support substrate (1) to a plurality of attachment points (34) on the device substrate (3), in order to be attached to the device substrate (3),
**characterized in that**
the apparatus (4) is adapted to rotate the support substrate (1) about an axis of rotation (R) that extends perpendicularly through the common plane of the plurality of cantilever pairs (13), in order to sequentially attach the nanostructures (2) to the device substrate (3).

10. The apparatus (4) according to claim 9, wherein the axis of rotation (R) is tilted or is tiltable with respect to the geometric normal (N) of a device substrate plane (P) in which the attachment points (34) are arranged.

11. The apparatus (4) according to claim 10, wherein the tilt angle (α) by which the axis of rotation (R) is tilted or is tiltable with respect to the geometric normal (N) of the device substrate plane (P) is in the range from 1° to 40°, preferably from 4° to 20°, in particular from 4° to 10°.

12. The apparatus (4) according to one of claims 9 to 11, wherein the apparatus (4) is adapted to move the support substrate (1) relative to the positioner (46) along an x-direction (x) extending perpendicular to the geometric normal (N) of a device substrate plane (P) in which the attachment points (34) are arranged.

13. The apparatus (4) according to claim 12, wherein the apparatus (4) is further adapted to move the support substrate (1) relative to the positioner (46) along a y-direction (y) extending perpendicular to both the x-direction (x) and the geometric normal (N).

14. A method for attaching nanostructures (2), in particular carbon nanotubes, to a device substrate (3), in particular by means of an apparatus (4) according to one of claims 9 to 13, wherein the nanostructures (2) are each arranged between a cantilever pair (13) of a support substrate (1) according to one of claims 1 to 8, the cantilever pairs (13) extending in different, non-parallel directions within a common plane, and wherein the method comprises at least the step of
- rotating the support substrate (1) about an axis of rotation (R) that extends perpendicularly through the common plane, in order to sequentially bring the nanostructures (2) from the support substrate (1) to a plurality of attachment points (34) on the device substrate (3), in order to attach the nanostructures (2) to the device substrate (3).

15. The method according to claim 14, wherein, for attaching the nanostructures (2) to the device substrate (3), the axis of rotation (R) is tilted with respect to the geometric normal (N) of a device substrate plane (P) in which the attachment points (34) are arranged.

## Patentansprüche

1. Ein Trägersubstrat (1) für Nanostrukturen (2), insbesondere für Kohlenstoffnanoröhren, wobei das Trägersubstrat (1) eine Vielzahl von Cantilever-Paaren (13) umfasst, die jeweils dazu ausgelegt sind, eine Nanostruktur (13) zwischen sich zu halten,
**dadurch gekennzeichnet, dass**
zumindest einige der Vielzahl von Cantilever-Paaren (13) entlang zumindest eines gekrümmten oder abgewinkelten Abschnitts des Umfangs (11) des Trägersubstrats (1) so angeordnet sind, dass sie sich in unterschiedlichen, nicht parallelen Richtungen erstrecken.

2. Das Trägersubstrat (1) nach Anspruch 1, wobei die Vielzahl von Cantilever-Paaren (13) entlang des gesamten Umfangs (11) des Trägersubstrats (1) verteilt sind.

3. Das Trägersubstrat (1) nach Anspruch 1 oder 2, wobei jedes der Cantilever-Paare (13) sich nach aussen entlang einer annähernd radialen Richtung erstreckt.

4. Das Trägersubstrat (1) nach einem der vorangehenden Ansprüche, wobei der Umfang (11) des Trägersubstrats (1) die Gesamtform eines Kreises oder eines regelmässigen Polygons beschreibt.

5. Das Trägersubstrat (1) nach einem der vorangehenden Ansprüche, wobei die Cantilever-Paare (13) in Gruppen (12) aus mehreren Cantilever-Paaren (13) angeordnet sind, die sich parallel zueinander erstrecken.

6. Das Trägersubstrat (1) nach Anspruch 5, wobei die Gruppen (12) aus mehreren sich parallel zueinander erstreckenden Cantilever-Paaren (13) in regelmässigen Abständen und vorzugsweise entlang des gesamten Umfangs (11) des Trägersubstrats (1) angeordnet sind.

7. Das Trägersubstrat (1) nach Anspruch 5 oder 6, wobei zwei beliebige benachbarte Gruppen (12) von Cantilever-Paaren (13), die sich parallel zueinander erstrecken, in einem Winkel von nicht mehr als 10°, vorzugsweise von nicht mehr als 8°, noch bevorzugter von nicht mehr als 6° zueinander stehen.

8. Das Trägersubstrat (1) gemäss einem der vorangehenden Ansprüche, wobei sich die Vielzahl von Cantilever-Paaren (13) innerhalb einer gemeinsamen Ebene erstrecken.

9. Eine Vorrichtung (4) zum Befestigen von Nanostrukturen (2), insbesondere Kohlenstoffnanoröhren, an einem Gerätesubstrat (3), wobei die Vorrichtung (4)
einen Halter (41) zum Halten eines Trägersubstrats (1) gemäss einem der vorstehenden Ansprüche, der eine Vielzahl von Cantilever-Paaren (13) umfasst, die sich innerhalb einer gemeinsamen Ebene in unterschiedlichen, nicht parallelen Richtungen erstrecken; und
einen Positionierer (46) zum Positionieren des Gerätesubstrats (3), am eine oder mehrere der Nanostrukturen (2) angebracht werden sollen, in Bezug auf das Trägersubstrat (1);
umfasst,
wobei die Vorrichtung (4) dazu ausgelegt ist, den Halter (41) und den Positionierer (46) relativ zueinander so zu bewegen, dass die Nanostrukturen (2), die jeweils zwischen einem Cantilever-Paar (13) gehalten sind, vom Trägersubstrat (1) zu einer Vielzahl von Befestigungspunkten (34) auf dem Gerätesubstrat (3) gebracht werden, um am Gerätesubstrat (3) befestigt zu werden,
**dadurch gekennzeichnet, dass**
die Vorrichtung (4) dazu ausgelegt ist, das Trägersubstrat (1) um eine Drehachse (R) zu drehen, die senkrecht durch die gemeinsame Ebene der Vielzahl von Cantilever-Paaren (13) verläuft, um die Nanostrukturen (2) nacheinander am Gerätesubstrat (3) anzubringen.

10. Die Vorrichtung (4) nach Anspruch 9, wobei die Drehachse (R) gegenüber der geometrischen Normalen (N) einer Gerätesubstrat-Ebene (P), in der die Befestigungspunkte (34) angeordnet sind, geneigt oder neigbar ist.

11. Die Vorrichtung (4) nach Anspruch 10, wobei der Neigungswinkel (α), um den die Drehachse (R) gegenüber der geometrischen Normalen (N) der Gerätesubstrat-Ebene (P) geneigt oder neigbar ist, im Bereich von 1° bis 40°, vorzugsweise von 4° bis 20°, insbesondere von 4° bis 10° liegt.

12. Die Vorrichtung (4) nach einem der Ansprüche 9 bis 11, wobei die Vorrichtung (4) dazu ausgelegt ist, das Trägersubstrat (1) relativ zum Positionierer (46) entlang einer x-Richtung (x) zu bewegen, die senkrecht zur geometrischen Normalen (N) einer Gerätesubstrat-Ebene (P) verläuft, in der die Befestigungspunkte (34) angeordnet sind.

13. Die Vorrichtung (4) nach Anspruch 12, wobei die Vorrichtung (4) ferner dazu ausgelegt ist, das Trägersubstrat (1) relativ zum Positionierer (46) entlang einer y-Richtung (y) zu bewegen, die senkrecht sowohl zur x-Richtung (x) als auch zur geometrischen Normalen (N) verläuft.

14. Ein Verfahren zum Anbringen von Nanostrukturen (2), insbesondere Kohlenstoffnanoröhren, an einem Gerätesubstrat (3), insbesondere mittels einer Vorrichtung (4) nach einem der Ansprüche 9 bis 13, wobei die Nanostrukturen (2) jeweils zwischen einem Cantilever-Paar (13) eines Trägersubstrats (1) nach einem der Ansprüche 1 bis 8 angeordnet sind, wobei sich die Cantilever-Paare (13) in unterschiedlichen, nicht parallelen Richtungen innerhalb einer gemeinsamen Ebene erstrecken, und wobei das Verfahren mindestens den Schritt umfasst
- Drehen des Trägersubstrats (1) um eine Drehachse (R), die senkrecht durch die gemeinsame Ebene verläuft, um die Nanostrukturen (2) nacheinander vom Trägersubstrat (1) zu einer Vielzahl von Befestigungspunkten (34) auf dem Gerätesubstrat (3) zu bringen, um die Nanostrukturen (2) am Gerätesubstrat (3) zu befestigen.

15. Das Verfahren nach Anspruch 14, wobei zum Befestigen der Nanostrukturen (2) am Gerätesubstrat (3) die Drehachse (R) in Bezug auf die geometrische Normale (N) einer Gerätesubstrat-Ebene (P), in der die Befestigungspunkte (34) angeordnet sind, geneigt ist.

## Revendications

1. Un substrat de support (1) pour nanostructures (2), en particulier pour nanotubes de carbone, le substrat de support (1) comprenant une pluralité de paires de cantilevers (13) qui sont chacun adaptés pour maintenir une nanostructure (13) entre ils,
**caractérisé en ce que**
au moins certaines de la pluralité de paires de cantilevers (13) sont disposés le long d'au moins une partie courbe ou angulaire de la circonférence (11) du substrat de support (1) de telle sorte qu'ils s'étendent dans des directions différentes et non parallèles.

2. Le substrat de support (1) selon la revendication 1, dans lequel la pluralité de paires de cantilevers (13) sont répartis le long de toute la circonférence (11) du substrat de support (1).

3. Le substrat de support (1) selon la revendication 1 ou 2, dans lequel chacun des paires de cantilevers (13) s'étend vers l'extérieur le long d'une direction approximativement radiale.

4. Le substrat de support (1) selon l'une des revendications précédentes, dans lequel la circonférence (11) du substrat de support (1) décrit la forme générale d'un cercle ou d'un polygone régulier.

5. Le substrat de support (1) selon l'une des revendications précédentes, dans lequel les paires de cantilevers (13) sont disposées en groupes (12) de plusieurs paires de cantilevers (13) s'étendant parallèlement les unes aux autres.

6. Le substrat de support (1) selon la revendication 5, dans lequel les groupes (12) de multiples paires de cantilevers (13) s'étendant parallèlement les uns aux autres sont disposés à des distances régulières et de préférence le long de toute la circonférence (11) du substrat de support (1).

7. Le substrat de support (1) selon les revendications 5 ou 6, dans lequel deux groupes adjacents (12) arbitraires de paires de cantilevers (13) s'étendant parallèlement l'un à l'autre forment entre eux un angle qui n'est pas supérieur à 10°, de préférence pas supérieur à 8°, plus préférablement pas supérieur à 6°.

8. Le substrat de support (1) selon l'une des revendications précédentes, dans lequel la pluralité de paires de cantilevers (13) s'étend dans un plan commun.

9. Un appareil (4) pour fixer des nanostructures (2), en particulier des nanotubes de carbone, à un substrat de dispositif (3), l'appareil (4) comprenant
un support (41) destiné à maintenir un substrat de support (1) selon l'une des revendications précédentes, comprenant une pluralité de paires de cantilevers (13) s'étendant dans un plan commun dans des directions différentes et non parallèles ; et
un positionneur (46) pour positionner le substrat de dispositif (3) auquel une ou plusieurs des nanostructures (2) doivent être fixées par rapport au substrat de support (1) ;
dans lequel l'appareil (4) est adapté pour déplacer le support (41) et le positionneur (46) l'un par rapport à l'autre de telle manière que les nanostructures (2), chacune maintenues entre une paire de cantilevers (13), soient amenées du substrat de support (1) à une pluralité de points de fixation (34) sur le substrat de dispositif (3), afin d'être fixées au substrat de dispositif (3),
**caractérisé en ce que**
l'appareil (4) est adapté pour faire tourner le substrat de support (1) autour d'un axe de rotation (R) qui s'étend perpendiculairement à travers le plan commun de la pluralité de paires de cantilevers (13), afin de fixer séquentiellement les nanostructures (2) au substrat de dispositif (3).

10. L'appareil (4) selon la revendication 9, dans lequel l'axe de rotation (R) est incliné ou inclinable par rapport à la normale géométrique (N) d'un plan de substrat de dispositif (P) dans lequel les points de fixation (34) sont disposés.

11. L'appareil (4) selon la revendication 10, dans lequel l'angle d'inclinaison (α) selon lequel l'axe de rotation (R) est incliné ou peut être incliné par rapport à la normale géométrique (N) du plan du substrat du dispositif (P) est compris entre 1° et 40°, de préférence entre 4° et 20°, en particulier entre 4° et 10°.

12. L'appareil (4) selon l'une des revendications 9 à 11, dans lequel l'appareil (4) est adapté pour déplacer le substrat de support (1) par rapport au positionneur (46) le long d'une direction x (x) s'étendant perpendiculairement à la normale géométrique (N) d'un plan de substrat de dispositif (P) dans lequel les points de fixation (34) sont disposés.

13. L'appareil (4) selon la revendication 12, dans lequel l'appareil (4) est en outre adapté pour déplacer le substrat de support (1) par rapport au positionneur (46) le long d'une direction y (y) s'étendant perpendiculairement à la fois à la direction x (x) et à la normale géométrique (N).

14. Un procédé pour fixer des nanostructures (2), en particulier des nanotubes de carbone, à un substrat de dispositif (3), en particulier au moyen d'un appareil (4) selon l'une des revendications 9 à 13, dans lequel les nanostructures (2) sont chacune disposées entre une paire de cantilevers (13) d'un substrat de support (1) selon l'une des revendications 1 à 8, les paires de cantilevers (13) s'étendant dans des directions différentes et non parallèles dans un plan commun, et dans lequel le procédé comprend au moins l'étape consistant à
- faire tourner le substrat de support (1) autour d'un axe de rotation (R) qui s'étend perpendiculairement à travers le plan commun, afin d'amener séquentiellement les nanostructures (2) du substrat de support (1) vers une pluralité de points de fixation (34) sur le substrat de dispositif (3), afin de fixer les nanostructures (2) au substrat de dispositif (3).

15. Le procédé selon la revendication 14, dans lequel, pour fixer les nanostructures (2) par rapport au substrat du dispositif (3), l'axe de rotation (R) est incliné par rapport à la normale géométrique (N) d'un plan du substrat du dispositif (P) dans lequel les points de fixation (34) sont disposés.
